# DEMANDE DE BREVET EUROPEEN

(11) **EP 0 553 006 A2**
(43) Date de publication de la demande: **28.07.1993**
(21) Numéro de dépôt: 93400092.8
(22) Date de dépôt: 15.01.1993
(51) Int. Cl.: H01L 21/338, H01L 21/033

(54) **Procédé de réalisation d'un transistor**

(30) Priorité: 24.01.1992 FR 9200748
(71) Demandeur: THOMSON-CSF SEMICONDUCTEURS SPECIFIQUES, 75008 Paris (FR)
(72) Inventeur: Pacou, Thierry, F-2402 Courbevoie Cedex (FR); Arsene-Henry, Patrice, F-2402 Courbevoie Cedex (FR); Pham Ngu Tung, F-2402 Courbevoie Cedex (FR); Genuist, Yann, F-2402 Courbevoie Cedex (FR)
(74) Mandataire: Guérin, Michel

(57) **Abrégé**

L'invention concerne la réalisation des régions d'accès de source (16) et de drain (17) d'un transistor à effet de champ, ces deux régions étant différenciées.

La région de commande est définie au moyen d'un masque tricouche métallique (4) , de résine (5) et métallique (6). Un masque de résine (8) protège la région d'accès (17) de drain, ce qui permet l'implantation de la région d'accès de source (16) . Après dissolution des résines (51, 8a), la région d'accès de drain (17) est implantée.

Application aux transistors à effet de champ de puissance.

## Description

La présente invention concerne un procédé de réalisation par technique d'autoalignement d'un transistor dont les régions d'accès sont différenciées. Plus précisément, ce procédé de réalisation,qui fait appel à trois couches de masquage, permet d'autoaligner la métallisation d'électrode de commande sur les deux régions d'accès, qui ont des caractéristiques différentes, en dimensions et en niveau de dopage.

Ce procédé est applicable à tous les transistors, de types bipolaire ou unipolaire, mais il est plus particulièrement adapté aux transistors à effet de champ et surtout à ceux qui, réalisés sur matériaux III-V tel que GaAs, fonctionnent en hyperfréquences.

Dans ce domaine, en effet, les très faibles dimensions submicroniques de la longueur de grille obligent le plus souvent à avoir recours à des techniques spéciales qui pallient à l'insuffisance de précision des moyens de masquage.

Les techniques d'autoalignement sont actuellement très utilisées en raison de leur influence sur le coût des fabrications et sur l'amélioration des performances. Cependant, dans le cas des transistors hyperfréquences sur matériaux III-V, pour lesquels il faut contrôler les résistances de grille, de source et de drain, respectivement R_{G}, R_{S} et R_{D}, il n'existe pas de technologie pratique et économique permettant de différencier les niveaux de dopage côté source, côté drain, sous la grille, et dans les caissons d'accès.

Par exemple, la technique connue sous le nom de "side wall", dans laquelle on utilise un masque déposé sur une face latérale d'un motif , autorise des implantations n' mais est incompatible avec des implantations n'' ou L_{DD} pour les grilles fines. (n' et n'' correspondent à deux niveaux de dopages intermédiaires entre peu dopé n et très dopé n+, et L_{DD} est une abréviation couramment employée pour désigner une région de drain peu dopée, "lightly doped drain").

Ou encore la technique du masque métallique en nickel, interdisant un nouveau masquage après surgravure de la grille et incompatible avec une gravure du masque côté source.

Enfin, la technique du masque diélectrique en SiO₂ est limitée par la sélectivité de gravure et n'est pas compatible avec des dopages n' et n'' différentiés.

Le procédé selon l'invention permet de réaliser les régions ayant des dopages différentiés dans un transistor hyperfréquences, en mettant en oeuvre des moyens simples de lithographie, dépôt, gravure, implantations . ..etc. Par exemple, un masqueur optique ayant une définition de 1 micromètre permet d'obtenir , selon le procédé de l'invention, des motifs définis à 0.2 micromètre, uniquement par gravure plasma . Ceci est obtenu au moyen d'un masquage tri-couche, dont deux couches métalliques. Un masque en résine, recuit à haute température, permet la gravure de la grille puis sa surgravure jusqu'à 0.2 µm, et l'implantation differenciée n' et n'' des régions côtés source et drain - ce qui permet de régler séparément les résistances d'accès R_{S} et R_{D} - et enfin l'implantation n⁺ des caissons de source et de drain. La région sous la grille est implantée avant les masquages.

De façon plus précise, l'invention réside en un procédé de réalisation d'un transistor dont les régions d'accès, de part et d'autre de la région de commande sont différenciées, ce procédé mettant en oeuvre les techniques d'autoalignement et étant caractérisé en ce qu'il utilise un masque à trois couches, composé d'une couche de résine recuite à haute température comprise entre deux couches métalliques.

L'invention sera mieux comprise par la description suivante d'un exemple d'application, en liaison avec les figures jointes en annexe qui représentent diverses étapes du procédé.

Le produit de départ est bien entendu une tranche de matériau semiconducteur qui a precédemment subi un certain nombre d'opérations visant à fabriquer de façon collective un type donne de dispositif semiconducteur, tel que transistor ou circuit intégré comportant au moins un transistor. Ces opérations peuvent inclure les épitaxies de types varies, des masquages, des gravures : elles se situent en dehors du domaine de l'invention et leurs traces ne sont pas représentées sur les figures.

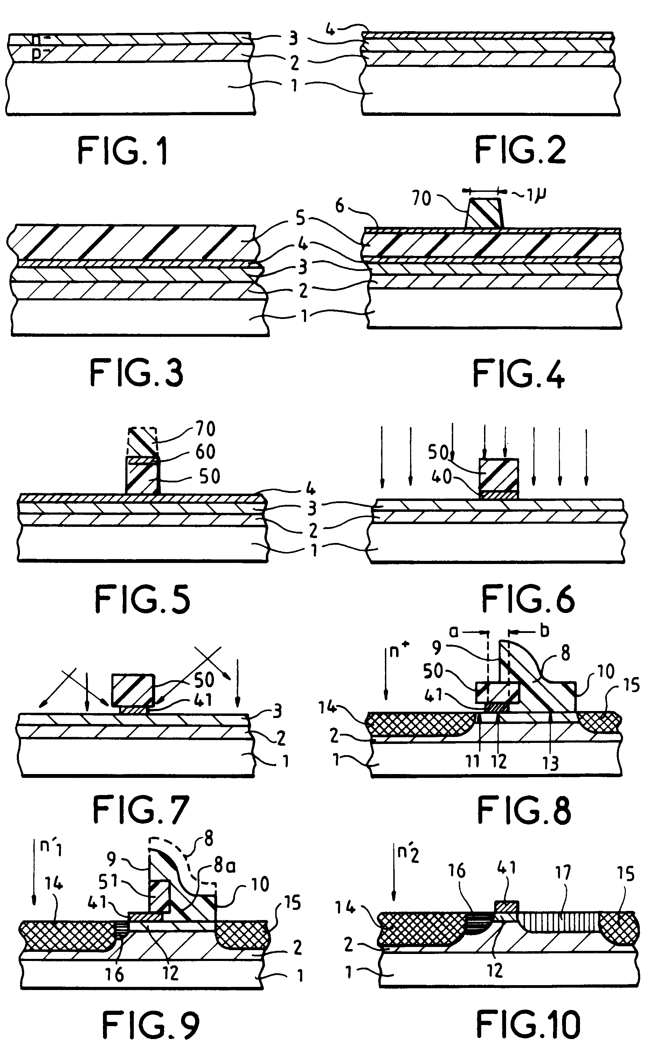

Toutefois, ces opérations antérieures ne doivent pas comporter de dopages qui modifient les régions superficielles. Ceci permet alors, comme représenté en figure 1 d'implanter dans un substrat 1 en GaAs semi-isolant par exemple une couche 2 dopée de type p⁻ et une couche 3 dopée de type n⁻ : la couche n⁻ constituera ultérieurement le canal du transistor.

Sur la face libre de la couche 3 est déposée (figure 2) une couche réfractaire 4, épaisse d'environ 4000 A°, en nitrure de tungstène/tungstène WN/W, qui constitue le premier masque métallique, puis une couche 5 de résine de masquage (figure 3). Déposée sous une épaisseur de l'ordre de 1,2 micromètre, cette résine est de type réticulable : elle est recuite à haute température pour la faire réticuler, 5 minutes à 260° C.

Sur cette couche 5 de résine est déposée une couche intermédiaire 6 de tungstène (figure 4), épaisse d'environ 200 à 300 A° : c'est le second masque métallique. Une seconde couche de résine réticulable est déposée sur le tungstène 6 : cette seconde couche n'est représentée sur la figure 4 que par ce qui en reste après masquage optique et lithographie, soit un motif 70. Ce motif, de dimension micronique, est le masque de la future grille du transistor.

Le masque 70 permet ensuite (figure 5) de former un nouveau masque qui résiste à la gravure et sous-gravure du tungstène, et aux implantations. Par gravure ionique réactive dite RIE, en présence d'hexafluorure de soufre , on grave la couche 6 de tungstène dont ne reste qu'un fragment 60 qui a été protégé par le motif 70. Puis par gravure ionique réactive en présence de 0₂ + Ar, on grave le masque de résine 70 et la couche de résine 5, dont ne reste qu'un fragment 50.

La métallisation de grille est gravée dans la couche 4 de WN/W (figure 6) par une troisième gravure, anisotrope, par RIE à basse pression en présence de NF₃ ou SF₆ : le fragment 60 de 200 A° d'épaisseur disparaît, et de la couche 4 de 4000 A° d'épaisseur ne reste qu'un fragment 40, qui, par reports successifs depuis la figure 4, a toujours une définition de l'ordre de 1 micromètre.

Cette définition est améliorée par une quatrième gravure ( figure 7), isotrope, par RIE sous haute pression en présence de SF₆ + C₂F₆. Cette gravure attaque le métal du fragment 41 de la couche de WN/W. Cette opération est appelée "surgravure" si l'on considère que le métal est davantage grave, ou "sous-gravure" si l'on considère qu'il est gravé sous le masque. Pour un motif 40 ayant 1 micromètre, le motif 41 peut avoir de l'ordre de 0,8 -0,6 micromètre de largeur.

Une nouvelle couche de résine épaisse est déposée sur la plaquette puis gravée pour définir un masque 8 tel que représenté en figure 8. Ce masque recouvre partiellement le masque 50 et le flanc 9 du masque 8 est situé entre les deux limites "a" et "b" qui correspondent aux bords du motif métallique 41. Le flanc 10 du masque 8 est situé à l'aplomb du bord du futur caisson de drain. Ainsi, le masque 50 en coopération avec le masque 8 recouvre toute la partie centrale du transistor : région d'accès 11 côté source, région 12 sous la grille, région d'accès 13 côté drain.

Une implantation ionique de type n⁺ permet alors de réaliser les caissons 14 de source et 15 de drain, dans l'épaisseur des couches semiconductrices 2 et 3 . A ce point du procédé , les trois régions 11,12 et 13 entre les deux caissons 14 et 15 ne sont pas différenciées : elles ont toutes trois le niveau de dopage de la couche 3 de départ.

L'étape suivante (figure 9) permet d'abord de différencier la région d'accès de source, en supprimant la partie du masque 50 qui protège la région 11 comprise entre la grille 41 et le caisson de source 14. Par gravure ionique réactive en présence d'oxygène on grave la dite partie du masque 50, jusqu'à la couche métallique 41. Mais cette gravure érode également le masque 8, qui diminue d'épaisseur et devient un masque 8a. Il faut donc, pour que le masque 8a soit efficace, que le masque 8 ait à l'origine une épaisseur sensiblement double de celle du masque 51.

Une implantation ionique de type n' (n < n'< n⁺) et de dose n'₁ crée la région d'accès de source 16.

Enfin (figure 10) est différentiée la région d'accès de drain. Pour cela, les masques de résine 51 et 8a sont dissous ou retirés par un moyen connu et une implantation ionique de type n' et de dose n'₂ crée la région d'accès de drain 17.

La dose n'₂ est plus petite que la dose n'₁, mais il faut en tenir compte pour le réglage de la résistance d'accès R_{S}, car la région de source 16 réçoit les deux doses n'₁ + n'₂.

Le bilan des implantations s'établit ainsi :
- région de grille 12 : n⁻
- région de source 16 : n⁻ + n'₁ + n'₂
- région de drain 17 : n'₂
- caissons de contacts 14 + 15: n⁻ + n⁺ + n'₁ +n'₂

La métallisation de grille 41 peut être, après planarisation par une résine, rechargée par électrolyse, pour diminuer sa résistance électrique.

Le procédé est applicable de préférence aux transistors de puissance, car il permet d'augmenter la tension drain-source V_{DS}.

## Revendications

**1 -** Procédé de réalisation d'un transistor dont les régions d'accès, de part et d'autre de la région de commande, sont différenciées, ce procédé mettant en oeuvre les techniques d'autoalignement et étant caractérisé en ce qu'il utilise un masque à trois couches, compose d'une couche de résine (5) recuite à haute température comprise entre deux couches métalliques (4, 6).

**2 -** Procédé selon la revendication 1, caractérisé en ce qu'il comporte les étapes suivantes :
a) sur un substrat (1) de matériau semiconducteur, implantation d'une couche (2), dopée de type p⁻, puis d'une couche (3), dopée de type n⁻,
b) dépôts successifs d'une première couche métallique (4), d'une première couche de résine (5), d'une seconde couche métallique (6) puis d'une seconde couche de résine, dans laquelle est définie un masque (70) correspondant à l'électrode de commande du transistor,
c) première gravure de la seconde couche métallique (60), seconde gravure de la première couche de résine (50), troisième gravure de la première couche métallique (40),
d) surgravure du motif métallique (40) sous le motif (50) restant de la première couche de résine
e) dépôt d'une troisième couche de résine et gravure dans cette couche d'un masque (8) dont un bord (9) est à l'aplomb du motif métallique surgravé (41) de l'étape précédente, et dont un second bord (10) est à l'aplomb d'un futur second caisson de contact d'electrode d'accès.
f) implantation ionique de type n⁺ des deux caissons (14,15) de contacts d'électrodes d'accès,
g) gravure partielle du motif (50) de la première couche de résine non protégé par le masque (8) de la troisième couche de résine, et implantation ionique de type n' (n < n'< n⁺) de la première région d'accès (16) située entre le motif surgravé (41) et un premier caisson d'accès (14).
h) dissolution des masques de résine restant (51,8) et implantation ionique de type n'de la deuxième région d'accès (17) situe entre le motif surgravé (41) et un second caisson d'accès (15).

**3 -** Procédé selon la revendication 2, caractérisé en ce que le transistor est un transistor à effet de champ, dont :
- la première région d'accès est la source,
- la seconde région d'accès est le drain,
- la région de commande est le canal (12) situé sous le motif surgravé (41) qui constitue la grille.

**4 -** Procédé selon la revendication 2, caractérisé en ce que la première couche de résine (5) subit un recuit de réticulation à haute température, 260° C, et en ce que la troisième couche de résine (8) est d'épaisseur supérieure à celle de la première couche de résine (5).
